# EUROPÄISCHE PATENTSCHRIFT

(11) **EP 0 853 613 B1**
(45) Veröffentlichungstag und Bekanntmachung des Hinweises auf die Patenterteilung: **09.01.2002**
(21) Anmeldenummer: 97928118.5
(22) Anmeldetag: 05.06.1997
(51) Int. Cl.: C07C 309/76, G03F 7/008, H01L 21/027, H01L 21/312, H01L 21/32

(54) **LICHTEMPFINDLICHER, WÄSSRIG-ALKALISCH ENTWICKELBARER, NEGATIV ARBEITENDER RESIST**
LIGHT-SENSITIVE RESIST WHICH CAN BE DEVELOPED IN AN AQUEOUS-ALKALI MANNER AND OPERATES NEGATIVELY
PRODUIT DE RESERVE PHOTOSENSIBLE REVELABLE DE MANIERE ALCALINO-AQUEUSE, FONCTIONNANT EN NEGATIF

(30) Priorität: 06.06.1996 DE 19623891
(43) Veröffentlichungstag der Anmeldung: 22.07.1998
(73) Patentinhaber: Micro Resist Technology GmbH, 12459 Berlin (DE)
(72) Erfinder: GRÜTZNER, Gabi, D-12689 Berlin (DE); VOIGT, Anja, D-13089 Berlin (DE); BENDIG, Jürgen, D-10369 Berlin (DE); SCHMIDT, Ines, D-12589 Berlin (DE); SAUER, Erika, D-13051 Berlin (DE)
(74) Vertreter: Bergelt, Klaus
(86) Internationale Anmeldenummer: DE9701176
(87) Internationale Veröffentlichungsnummer: WO9746519

(56) Entgegenhaltungen:
- EP-A- 0 297 153
- US-A- 4 835 089

## Beschreibung

Die Erfindung betrifft einen lichtempfindlichen, wäßrig-alkalisch entwickelbaren, negativ arbeitenden Resist, bestehend aus einem polymeren Bindemittel, einer lichtempfindlichen Komponente, einem Lösungsmittel oder Lösungsmittelgemisch und schichtbildender und/ oder schichtstabilisierender Zusätze gemäß Hauptanspruch 1 und ein Verfahren zur Herstellung von lichtempfindlichen Komponenten für wäßrig-alkalisch entwickelbare, negativ arbeitende Resiste gemäß Hauptanspruch 8 und ein Verfahren zur Herstellung von Negativstrukturen für den µm- und nm-Bereich gemäß Hauptanspruch 11.

Der größte Teil der kommerziell angebotenen negativ-arbeitenden Photoresiste wird auf nichtwäßriger Basis gefertigt. Da bei diesen Resisten auch bei der Resistverarbeitung, speziell bei der Entwicklung der belichteten Resistbereiche, organische Lösungsmittel eingesetzt werden müssen, sinkt das Anwenderinteresse kontinuierlich aufgrund der dadurch erhöhten Umweltbelastung und der begrenzten Leistungsparameter verursacht durch die Resistquellung beim Entwickeln (keine Maßhaltigkeit bei der Übertragung der Struktur Maske im Resist) [H. Böttcher; J. Bendig; M.-A. Fox; G. Hopf; H.-J. Timpe: Technical Applications of Photochemistry, Verlag für Grundstoffindustrie, Leipzig 1991, S.178ff].

Als wäßrig-alkalisch entwickelbare, nicht quellende, negativ arbeitende Photoresiste werden die Raycast-Serie [S. Nonogaki: Polym. J. 19 (1987) S. 99] und die Waycoat-Resiste [M.-A. Toukhy; S.F. Mariotte: SPIE Advances in Resist Technology and Proccesing 469 (1984) S. 86] verwendet.

Die Hauptbestandteile der Raycast-Serie (mit den Resisten RD 2000N, RU 1000N und RG 3000N) sind Polyvinylphenol (PVPh) als polymeres Bindemittel, ein resistspezifisches Azid oder Bisazid als lichtempfindliche Komponente und 2-Methoxyethylacetat als Lösungsmittel. Der Resist RD 2000N wird im Tief UV-Bereich (DUV) verwendet. Die Resiste RU 1000N und RG 3000N haben ihre höchste Empfindlichkeit im UV- (308 nm, 313/320 nm, 365 nm) bzw. im UV/Vis- (365 nm, 406 nm, 436 nm) Bereich. Die in den Resisten RU 1000N und RG 3000N verwendeten lichtempfindlichen Komponenten zeigen nur eine begrenzte Löslichkeit in der Polymerlösung; die Resiste weisen daher einen geringen Feststoffgehalt auf. Die maximal erreichbaren Schichtdicken des auf ein Substrat aufgebrachten Resistes betragen 2 µm.

PVPh besitzt eine hervorragende Löslichkeit, insbesondere in den resistüblichen Lösungsmitteln; von großem Nachteil sind die hohen Herstellungskosten.

Die Waycoat-Resiste bestehen auf der Basis Novolak als polymeres Bindemittel. Der verwendete Novolak zeigt gegenüber basischen Lösungen eine sehr geringe Ätzstabilität. Das verwendete Lösungsmittel ist stark toxisch. Der Resist ist empfindlich im DUV-Bereich.

Die Aufgabe der Erfindung beinhaltet die Bereitstellung eines lichtempfindlichen, wäßrig-alkalisch entwickelbaren, negativ arbeitenden Resistes bestehend aus einem polymeren Bindemittel mit guten Löseeigenschaften und einer hohen Ätzstabilität und einer lichtempfindlichen Komponente, die über einen weiten spektralen Bereich hohe Empfindlichkeit und eine hohe Photoreaktivität aufweist und gute Löseeigenschafte in der Polymerlösung zeigt und ein Verfahren zur ökonomischen Herstellung der lichtempfindlichen Komponente.

Die Lösung der Aufgabe erfolgt gemäß den kennzeichnenden Teilen der Ansprüche 1, 8 und 11. Weiterbildungen der Erfindung sind in den Unteransprüchen beschrieben.

Die Erfindung weist verschiedene Vorteile auf.

Als polymeres Bindemittel kann alternativ zum PVPh ein Novolak (Phenol/Kresol-Formaldehyd/oligo/isomerenkondensationsgemisch verwendet werden. Novolake werden in einem Ein- oder Zweistufenverfahren hergestellt, deren Herstellung ist aber wesentlich kostengünstiger als die Herstellung von PVPh. Novolake zeigen eine ausgezeichnete Löslichkeit u.a. in Alkoholen, Aceton, Carbonsäureestern und wässig-alkalischen Lösungen.

Vorteilhaft ist der Einsatz umweltfreundlicher nichttoxischer Lösungsmittel im Resist.

Als lichtempfindliche Komponente wird ein Diazidostilben-disulfonsäureester verwendet. Der Diazidostilben-disulfonsäureester weist eine ausgezeichnete Löslichkeit im angegeben Lösungsmittel bzw. Lösungsmittelgemisch und in der Polymerlösung auf, wodurch ein hoher Feststoffgehalt im Resist ermöglicht wird. Aufgrund der hohen Photoreaktivität und der weiten spektralen Empfindlichkeit dieser Verbindungen im Bereich von 200 bis 400 nm (DUV- und UV-Bereich) wird das Belichten der Resistschichten neben der bisher eingesetzten Spezial Quarzoptik auch mit herkömmlicher Glasoptik ermöglicht.

Der Feststoffgehalt im Resist und somit entsprechend der Gehalt an lichtempfindlicher Komponente vom Feststoffgehalt ist durch die ausgezeichnete Löslichkeit der Einzelkomponenten Phenolharz und lichtempfindlicher Komponente in den angegebenen Lösungsmitteln bzw. Lösungsmittelgemischen in weiten Bereichen variierbar, so daß je nach Anforderungen gewünschte Schichtdicken von 0,3 bis 10 µm erhalten werden.

Die kostengünstige Synthese eines Diazidostilben-disulfonsäureesters als lichtempfindliche Komponente erfolgt in einem einfach durchzuführenden Zweistufenprozeß, welcher mit hoher Ausbeute verläuft.

Von großem Vorteil ist der Einsatz von umweltverträglichen und nichttoxischen Entwicklern auf wäßriger Basis.

Der erfindungsgemäße Resist ist geeignet im lithographischen Standardprozeß (AZ-kompatibel) Mikrostrukturen bis zu einer Auflösung < 0,5 µm zu erzeugen, die eine hohe Maßhaltigkeit (1 : 1 Übertragung der Struktur von Maske in Resist), eine hohe Kantenschärfe und sehr gute Ätzstabilität aufweisen.

Die Erfindung wird anhand der nachfolgend aufgeführten Ausführungsbeispiele näher erläutert.

### Beispiel 1

In 144 g Ethyllactat, versetzt mit 0,028 g polyethermodifiziertem Polydimethylsiloxan, werden bei Raumtemperatur 42 g Novolak (m-Kresol/p-Kresol/Formaldehyd-Harz) eingerührt bis eine Auflösung des Polymeren erfolgt und eine klare Lösung entstanden ist. In diese Lösung werden anschließend 14 g 4,4'-Diazidostilben-2,2' - di(sulfonsäurebutoxyethylester) eingerührt bis eine klare rötliche Lösung entsteht.
Es werden 200 g Resist mit einem Feststoffanteil von 28 Gew.% erhalten.

### Beispiel 2

In 145 g Ethyllactat, versetzt mit 0,052 g polyethermodifiziertem Polydimethylsiloxan, werden bei Raumtemperatur 84 g Novolak (o-Kresol/p-Kresol/Formaldehyd-Harz) eingerührt bis eine Auflösung des Polymeren erfolgt und eine klare Lösung entstanden ist. In diese Lösung werden anschließend 21 g 4,4'-Diazidostilben-2,2'- di(sulfonsäurebutoxyethylester) eingerührt bis eine klare Lösung entsteht.
Es werden 250 g Resist mit einem Feststoffgehalt von 42 Gew.% erhalten.

### Beispiel 3

In 345 g Ethylglycolacetat, versetzt mit 0,078 g polyethermodifiziertem Polydimethylsiloxan, werden bei Raumtemperatur 124g poly-(p-hydroxystyrol) eingetragen und unter Rühren gelöst. Anschließend erfolgt unter Rühren die Zugabe von 31 g 4,4'-Diazidostilben-2,2'-di(sulfonsäurebutoxyethylester) bis eine klare Lösung entstanden ist.
Es werden 500 g Resist mit einem Feststoffgehalt von 31 Gew.% erhalten.

### Beispiel 4

### Synthese des 4,4'-Diazidostilben-2,2'-di(sulfonsäurebutoxyethylester)

20 g (0,037 mol) 4,4'-Diazidostilben-2,2'-disulfonsaures Natriumsalz Tetrahydrat werden in 100 ml (1,39 mol) Thionylchlorid (250 ml Rundkolben, Rückflußkühler mit Gasableitungsrohr in ca. 0,2 M NaOH-Lösung) unter Rühren bei Raumtemperatur mit 12 ml (0,155 mol) Dimethylformamid (DMF) zur Reaktion gebracht. Nach Beendigung der Reaktion (ca. 2 h) wird das überschüssige Thionylchlorid vorsichtig abrotiert (Vakuum, 50 °C) und die gelbe Masse auf Eiswasser gegossen (Abzug!), abgesaugt und mehrmals mit Wasser gewaschen.
Ausbeute: 17,5 g **4,4'-Diazidostilben-2,2'-disulfochlorid.**
Schmp. 195...197°C, gelbe Kristalle,

| | | | | | | |
|---|---|---|---|---|---|---|
| Elementaranalyse: C₁₄H₈N₆O₄S₂Cl₂ (458,9): | ber. | C 36,6; | H 1,74; | N 18,4; | S 13,9; | Cl 15,44. |
| | gef. | C 35,5; | H 1,89; | N 17,8; | S 13,9; | Cl 14,8. |

2,3 g (5 x 10⁻³ mol) 4,4'-Diazidostilben-2,2'-disulfochlorid werden in 9,4 g (8 x 10⁻² mol) Buthoxyethanol suspendiert. Bei der portionsweisen Zugabe von 1,5 g frisch bereitetem, feinst gepulvertem KOH sollte die Temperatur 4-5°C nicht überschreiten. Nach ca. 2-3 stündigem Rühren wird der Niederschlag abgesaugt, mit Wasser gewaschen und in Ethanol umkristallisiert.
Ausbeute: 2,2 g **4,4'-Diazidostilben-2,2'-di(sulfonsäurebutoxyethylester)**
Schmp. 86°c, gelblich-weiße Kristalle.

| | | | | | |
|---|---|---|---|---|---|
| Elementaranalyse: C₂₆H₃₄N₆S₂O₈ (622,72) | ber. | C 50,1; | H 5,45; | N 13,5; | S 10,27. |
| | gef. | C 49,9; | H 5,40; | N 13,6; | S 10,53. |

### Beispiel 5

### Synthese des 4,4'-Diazidostilben-2,2'-di(sulfonsäureethoxyethylester)

2,3 g (5 x 10⁻³ mol) 4,4'-Diazidostilben-2,2'-disulfochlorid entsprechend Beispiel 4 werden in 5,9 g (8 x 10⁻² mol) Ethoxyethanol suspendiert. Bei der portionsweisen Zugabe von 1,5 g frisch bereitetem, feinst gepulvertem KOH sollte die Temperatur 4-5°C nicht überschreiten. Nach ca. 2-3 stündigem Rühren wird der Niederschlag abgesaugt, mit Wasser gewaschen und in Ethanol umkristallisiert.
Ausbeute: 2 g **4,4'-Diazidostilben-2,2'-di(sulfonsäureethoxyethylester).**
gelblich-weiße Kristalle

| | | | | | |
|---|---|---|---|---|---|
| Elementaranalyse C₂₂H₂₆N₆S₂O₈ (566) | ber. | C 46,6; | H 4,59; | N 14,8; | S 11,3. |
| | gef. | C 46,9; | H 4,39; | N 14,6; | S 11,63. |

### Beispiel 6

2"-Si-Wafer werden 30 s bei 3000 min⁻¹ mit einem Resist entsprechend Beispiel 1 schleuderbeschichtet (Schichtdicke 1,5 µm). Die erhaltenen Schichten werden 2 Minuten bei 80°C einer hot-platc-Trocknung unterzogen und anschließend mit einer Hg-Höchstdrucklampe (λ = 365 nm) 60 s mit einer Leistungsdichte von P = 10,8 mW cm ⁻² bildmäßig belichtet. Die belichteten Schichten werden 50 s mit 0,8 Gew.%iger NaOH entwickelt und 15 s im Stickstoffstrom getrocknet.

### Beispiel 7

Resistschichten präpariert entsprechend Beispiel 6 werden mit einer Hg-Höchstdrucklampe (λ - 365 nm) 40 s mit einer Leistungsdichte von P = 10,8 mW cm⁻² bildmäßig belichtet.
Die belichteten Schichten werden 70 s mit 2,5 Gew.%iger Tetramethylammoniumhydroxid-Lösung entwickelt und 15 s im Stickstoffstrom getrocknet.

### Beispiel 8

Resistschichten präpariert und belichtet entsprechend Beispiel 7 werden 35 s in 3,3 Gew.%iger Tetramethylammoniumhydroxid-Lösung entwickelt und 15 s im Stickstoffstrom getrocknet.

### Beispiel 9

4"-Si-Wafer werden 30 s bei 3000 min⁻¹ mit einem Resist entsprechend Beispiel 2 schleuderbeschichtet (Schichtdicke 4,7 µm). Die erhaltenen Schichten werden 30 Minuten bei 95°C im Ofen getrocknet. Anschließend werden die Schichten mit einer Hg-Höchstdrucklampe (λ = 365 nm) 60 s mit einer Leistungsdichte von 9,5 mW cm⁻² bildmäßig belichtet. Die belichteten Schichten werden 3 Minuten mit 0,8 Gew.%iger NaOH entwickelt und 25 s im Stickstoffstrom getrocknet.

### Beispiel 10

4"-Si-Wafer beschichtet und belichtet entsprechend Beispiel 9 werden 4 Minuten und 45 s mit 2,5 Gew.%iger Tetramethylammoniumhydroxid-Lösung entwickelt und 25 s im Stickstoffstrom getrocknet.

### Beispiel 11

4"-Si-Wafer beschichtet und belichtet entsprechend Beispiel 9 werden 3 Minuten in 3,3 Gew.%iger Tetramethylammoniumhydroxid-Lösung entwickelt und 25 s im Stickstoffstrom getrocknet.

## Patentansprüche

1. Lichtempfindlicher, wäßrig-alkalisch entwickelbarer, negativ arbeitender Resist, **gekennzeichnet dadurch, daß** der Resist
- ein Phenolharz als polymeres Bindemittel,
- ein Diazidostilben-disulfonsäureester der allgemeinen Formel I als lichtempfindliche Komponente 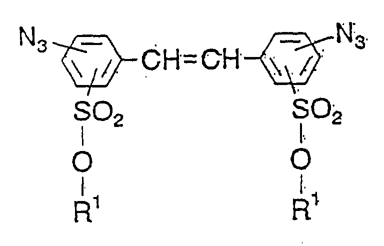
in der R¹ ein Rest der allgemeinen Formel II 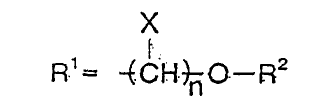
R² für Wasserstoff, verzweigtes und unverzweigtes Alkyl
X für Wasserstoff, verzweigtes und unverzweigtes Alkyl und
n für 1 bis 10
stehen
- ein Lösungsmittel oder Lösungsmittelgemisch und
- schichtbildende und/oder schichtstabilisierende Zusätze enthält.

2. Lichtempfindlicher, wäßrig-alkalisch entwickelbarer, negativ arbeitender Resist, der nach Anspruch 1 ein Phenolharz als polymeres Bindemittel, einen Diazidostilben-disulfonsäureester als lichtempfindliche Komponente, ein Lösungsmittel oder Lösungsmittelgemisch und schichtbildende und/oder schichtstabilisierende Zusätze enthält, **gekennzeichnet dadurch, daß** der Resist als polymeres Bindemittel ein Phenol-Formaldehyd- oder Kresol-Formaldehyd-Kondensat oder unsubstituiertes oder substituiertes Polyvinylphenol oder Gemische derselben enthält.

3. Lichtempfindlicher, wäßrig-alkalisch entwickelbarer, negativ arbeitender Resist, der nach Anspruch 1 ein Phenolharz als polymeres Bindemittel, einen Diazidostilben-disulfonsäureester als lichtempfindliche Komponente, ein Lösungsmittel oder Lösungsmittelgemisch und schichtbildende und/oder schichtstabilisierende Zusätze enthält, **gekennzeichnet dadurch, daß** der Resist
als lichtempfindliche Komponente ein Diazidostilben-disulfonsäureester der allgemeinen Formel I 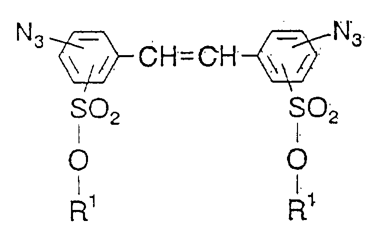 enthält, in der
R¹ ein Rest der allgemeinen Formel II 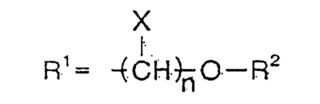 darstellt,
wobei R² für Wasserstoff, verzweigtes und unverzweigtes Alkyl,
X für Wasserstoff, verzweigtes und unverzweigtes Alkyl und
n für 1 bis 10
stehen.

4. Lichtempfindlicher, wäßrig-alkalisch entwickelbarer, negativ arbeitender Resist, der nach Anspruch 1 ein Phenolharz als polymeres Bindemittel, einen Diazidostilben-disulfonsäureester als lichtempfindliche Komponente, ein Lösungsmittel oder Lösungsmittelgemisch und schichtbildende und/oder schichtstabilisierende Zusätze enthält, **gekennzeichnet dadurch, daß** der Resist
einen Feststoffanteil von 5 Gew.% bis 50 Gew.% besitzt.

5. Lichtempfindlicher, wäßrig-alkalisch entwickelbarer, negativ arbeitender Resist, der nach Anspruch 1 ein Phenolharz als polymeres Bindemittel, einen Diazidostilben-disulfonsäure ester als lichtempfindliche Komponente, ein Lösungsmittel oder Lösungsmittelgemisch und schichtbildende und/oder schichtstabilisierende Zusätze enthält, und nach Anspruch 4, **gekennzeichnet dadurch, daß** der Resist
einen Anteil an lichtempfindlicher Komponente im Feststoff von 5 Gew.% bis 35 Gew.% besitzt.

6. Lichtempfindlicher, wäßrig-alkalisch entwickelbarer, negativ arbeitender Resist, der nach Anspruch 1 ein Phenolharz als polymeres Bindemittel, einen Diazidostilben-disulfonsäureester als lichtempfindliche Komponente, ein Lösungsmittel oder Lösungsmittelgemisch und schichtbildende und/oder schichtstabilisierende Zusätze enthält, **gekennzeichnet dadurch, daß** der Resist
als Lösungsmittel Ester, Ketone, Alkohole, Aromaten, Ether oder Gemische derselben enthält.

7. Lichtempfindlicher, wäßrig-alkalisch entwickelbarer, negativ arbeitender Resist, der nach Anspruch 1 ein Phenolharz als polymeres Bindemittel, einen Diazidostilben-disulfonsäureester als lichtempfindliche Komponente, ein Lösungsmittel oder Lösungsmittelgemisch und schichtbildende und/oder schichtstabilisierende Zusätze enthält, **gekennzeichnet dadurch, daß** der Resist
als schichtbildende und/oder schichtstabilisierende Zusätze Tenside, Glätter oder Haftvermittler enthält.

8. Verfahren zur Herstellung lichtempfindlicher Komponenten der allgemeinen Formel I 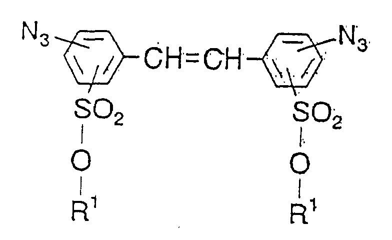 für wäßrig-alkalisch entwickelbare, negativ arbeitende Resiste, **gekennzeichnet dadurch, daß**
- ein Diazidostilben-disulfonsäure-Dinatriumsalz mit Thionylchlorid so sulfochloriert wird, daß bezogen auf die Menge an Dinatriumsalz stöchiometrische Mengen an Dimethylformamid zugesetzt werden, und
- das erhaltene Diazidostilben-disulfochlorid mit einem Alkohol der allgemeinen Formel III, 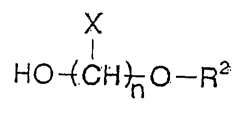 in der
R² für Wasserstoff, verzweigtes und unverzweigtes Alkyl,
X für Wasserstoff, verzweigtes und unverzweigtes Alkyl und
n für 1 bis 10 stehen,
bei Anwesenheit säurebindender Zusätze
umgesetzt wird.

9. Verfahren zur Herstellung lichtempfindlicher Komponenten der allgemeinen Formel I 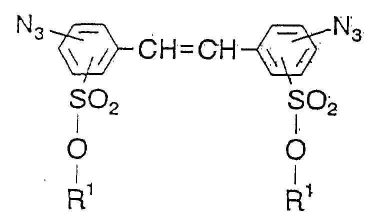 entsprechend Anspruch 8, **gekennzeichnet dadurch,**
**daß**
das Thionylchlorid im Überschuß zugesetzt wird.

10. Verfahren zur Herstellung lichtempfindlicher Komponenten der allgemeinen Formel I 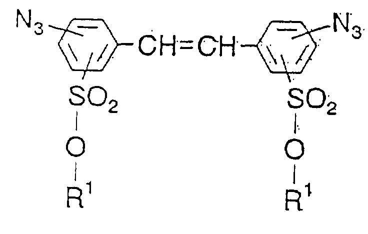 entsprechend Anspruch 8, **gekennzeichnet dadurch,**
**daß**
als säurebindende Mittel Pyridin, Ätznatron oder Ätzkali zugesetzt werden.

11. Verfahren zur lithographischen Herstellung von Negativstrukturen für den µm- und nm-Bereich, **gekennzeichnet dadurch, daß**
- ein Photoresist bestehend aus einem Phenolharz, einer lichtempfindlichen Komponente der allgemeinen Formel I 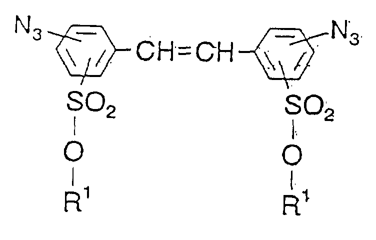
wobei R¹ ein Rest der allgemeinen Formel II 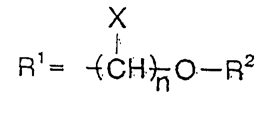
R² für Wasserstoff, verzweigtes und unverzweigtes Alkyl,
X für Wasserstoff, verzweigtes und unverzweigtes Alkyl und
n für 1 bis 10
stehen
mit den angegebenen Bedeutungen für R¹, R²,
X und n, einem Lösungsmittel oder Lösungsmittelgemisch und schichtbildenden und/ oder schichtstabilisierenden Zusätzen eingesetzt wird,
- der Resist als Schicht auf das Substrat aufgebracht wird,
- die Resistschicht getrocknet wird,
- die Resistschicht bildmäßig im Wellenlängenbereich 200 nm bis 400 nm belichtet wird,
- die belichtete Schicht mit einem wäßrig-alkalischen Entwickler entwickelt wird, und
- die erhaltene Struktur getrocknet wird.

12. Verfahren zur lithographischen Herstellung von Negativstrukturen für den µm- und nm-Bereich entsprechend Anspruch 11, wobei der eingesetzte Resist ein Phenolharz als polymeres Bindemittel, einen Diazidostilben-disulfonsäureester als lichtempfindliche Komponente, ein Lösungsmittel oder Lösungsmittelgemisch und schichtbildende und/oder schichtstabilisierende Zusätze enthält, **gekennzeichnet dadurch, daß** für die Beschichtung des Substrates die Schleuderbeschichtung (spincoating), das Rollercoating, die Sprühbeschichtung, die Spraybeschichtung oder die Tauchbeschichtung
angewandt werden.

13. Verfahren zur lithographischen Herstellung von Negativstrukturen für den µm- und nm-Bereich entsprechend Anspruch 11, wobei der eingesetzte Resist ein Phenolharz als polymeres Bindemittel, einen Diazidostilben-disulfonsäureester als lichtempfindliche Komponente, ein Lösungsmittel oder Lösungsmittelgemisch und schichtbildende und/oder schichtstabilisierende Zusätze enthält, **gekennzeichnet dadurch, daß** bei der Beschichtung Schichtdicken von 0,3 µm bis 10 µm erzeugt werden.

14. Verfahren zur lithographischen Herstellung von Negativstrukturen für den µm- und nm-Bereich entsprechend Anspruch 11, wobei der eingesetzte Resist ein Phenolharz als polymeres Bindemittel, einen Diazidostilben-disulfonsäureester als lichtempfindliche Komponente, ein Lösungsmittel oder Lösungsmittelgemisch und schichtbildende und/oder schichtstabilisierende Zusätze enthält, **gekennzeichnet dadurch, daß**
der Trocknungsprozeß 1 Minute bis 60 Minuten bei 60°C bis 120°C durchgeführt wird.

15. Verfahren zur lithographischen Herstellung von Negativstrukturen für den µm- und nm-Bereich entsprechend Anspruch 11, wobei der eingesetzte Resist ein Phenolharz als polymeres Bindemittel, einen Diazidostilben-disulfonsäureester als lichtempfindliche Komponente, ein Lösungsmittel oder Lösungsmittelgemisch und schichtbildende und/oder schichtstabilisierende Zusätze enthält, **gekennzeichnet dadurch, daß**
für die Belichtung Höchstdrucklampen oder Laser eingesetzt werden.

16. Verfahren zur lithographischen Herstellung von Negativstrukturen für den µm- und nm-Bereich entsprechend Anspruch 11, wobei der eingesetzte Resist ein Phenolharz als polymeres Bindemittel, einen Diazidostilben-disulfonsäureester als lichtempfindliche Komponente, ein Lösungsmittel oder Lösungsmittelgemisch und schichtbildende und/oder schichtstabilisierende Zusätze enthält, **gekennzeichnet dadurch, daß**
für die Entwicklung der belichteten Schichten alkalimetallionenhaltige Entwickler mit einer Konzentration von 0,2 Gew.% bis 1,5 Gew.% oder metallionenfreie Entwickler mit einer Konzentration von 1 Gew.% bis 5 Gew.% eingesetzt werden.

17. Verfahren zur lithographischen Herstellung von Negativstrukturen für den µm- und nm-Bereich entsprechend Anspruch 11, wobei der eingesetzte Resist ein Phenolharz als polymeres Bindemittel, einen Diazidostilben-disulfonsäureester als lichtempfindliche Komponente, ein Lösungsmittel oder Lösungsmittelgemisch und schichtbildende und/oder schichtstabilisierende Zusätze enthält, und Anspruch 16, wobei alkalimetallionenhaltige oder metallionenfreie Entwickler eingesetzt werden, **gekennzeichnet dadurch, daß** die Entwicklungszeit 10 s bis 15 Minuten beträgt.

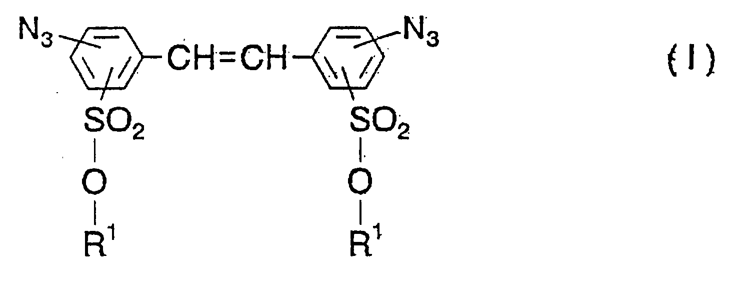

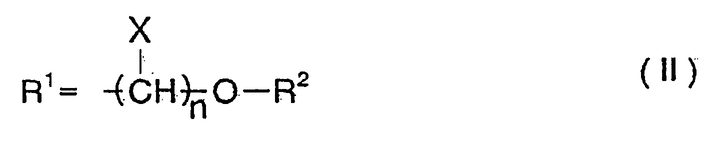

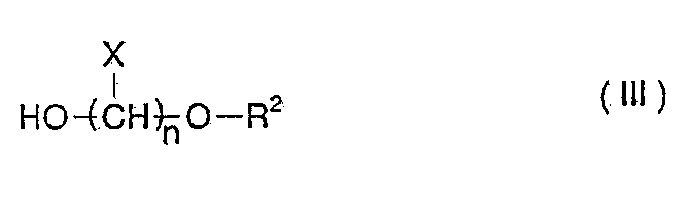

## Claims

1. Light-sensitive, negative-working resist which can be developed in aqueous-alkaline media, **characterized in that** the resist comprises
- a phenolic resin as polymeric binder
- a diazidostilbenedisulphonic acid ester of the general formula I as light-sensitive component 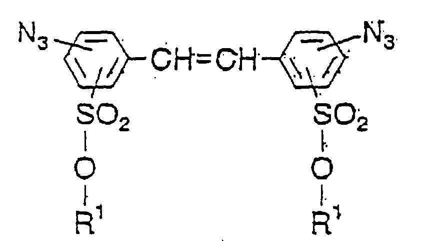 in which R¹ is a radical of the general formula II 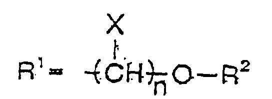
R² is hydrogen, branched or unbranched alkyl,
X is hydrogen, branched or unbranched alkyl, and
n is from 1 to 10,
- a solvent or solvent mixture, and
- layer-forming and/or layer-stabilizing additives.

2. Light-sensitive, negative-working resist which can be developed in aqueous-alkaline media, which comprises, in accordance with Claim 1, a phenolic resin as polymeric binder, a diazidostilbenedisulphonic acid ester as light-sensitive component, a solvent or solvent mixture and layer-forming and/or layer-stabilizing additives, **characterized in that** the resist comprises,
as polymeric binder, a phenol-formaldehyde or cresolformaldehyde condensate or unsubstituted or substituted polyvinylphenol, or mixtures thereof.

3. Light-sensitive, negative-working resist which can be developed in aqueous-alkaline media, which comprises, in accordance with Claim 1, a phenolic resin as polymeric binder, a diazidostilbenedisulphonic acid ester as light-sensitive component, a solvent or solvent mixture and layer-forming and/or layer-stabilizing additives, **characterized in that** the resist comprises,
as light-sensitive component, a diazidostilbenedisulphonic acid ester of the general formula 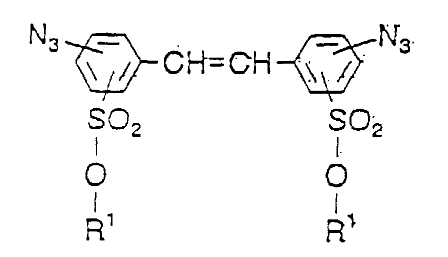 in which
R¹ is a radical of the general formula II 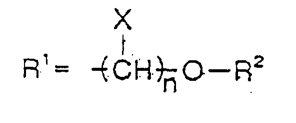 where R² is hydrogen, branched or unbranched alkyl,
X is hydrogen, branched or unbranched alkyl, and
n is from 1 to 10.

4. Light-sensitive, negative-working resist which can be developed in aqueous-alkaline media, which comprises, in accordance with Claim 1, a phenolic resin as polymeric binder, a diazidostilbenedisulphonic acid ester as light-sensitive component, a solvent or solvent mixture and layer-forming and/or layer-stabilizing additives, **characterized in that** the resist has
a solids content of from 5% by weight to 50% by weight.

5. Light-sensitive, negative-working resist which can be developed in aqueous-alkaline media, which comprises, in accordance with Claim 1, a phenolic resin as polymeric binder, a diazidostilbenedisulphonic acid ester as light-sensitive component, a solvent or solvent mixture and layer-forming and/or layer-stabilizing additives, and, in accordance with Claim 4, **characterized in that** the resist has
a proportion of light-sensitive component in the solid of from 5% by weight to 35% by weight.

6. Light-sensitive, negative-working resist which can be developed in aqueous-alkaline media, which comprises, in accordance with Claim 1, a phenolic resin as polymeric binder, a diazidostilbenedisulphonic acid ester as light-sensitive component, a solvent or solvent mixture and layer-forming and/or layer-stabilizing additives, **characterized in that** the resist comprises,
as solvent, esters, ketones, alcohols, aromatic compounds, ethers or mixtures thereof.

7. Light-sensitive, negative-working resist which can be developed in aqueous-alkaline media, which comprises, in accordance with Claim 1, a phenolic resin as polymeric binder, a diazidostilbenedisulphonic acid ester as light-sensitive component, a solvent or solvent mixture and layer-forming and/or layer-stabilizing additives, **characterized in that** the resist comprises,
as layer-forming and/or layer-stabilizing additives, surfactants, smoothing agents or adhesion promoters.

8. Process for the preparation of light-sensitive components of the general formula I 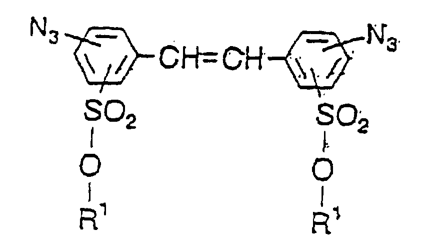 for negative-working resists which can be developed in aqueous-alkaline media, **characterized in that**
- a diazidostilbenedisulphonic acid disodium salt is sulphochlorinated using thionyl chloride in such a way that, based on the amount of disodium salt, stoichiometric amounts of dimethylformamide are added, and
- the resultant diazidostilbenedisulpho chloride is reacted with an alcohol of the general formula III 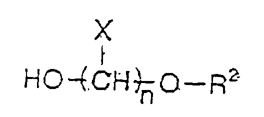 in which
R² is hydrogen, branched or unbranched alkyl,
X is hydrogen, branched or unbranched alkyl, and
n is from 1 to 10,
in the presence of acid-binding additives.

9. Process for the preparation of light-sensitive components of the general formula I 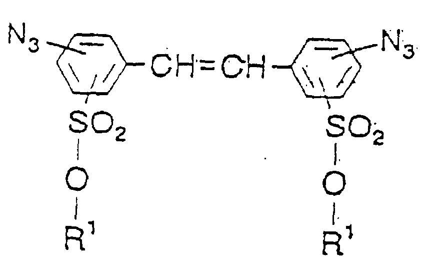 corresponding to Claim 8, **characterized in that** the thionyl chloride is added in excess.

10. Process for the preparation of light-sensitive components of the general formula I 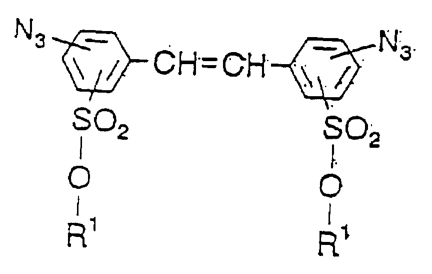 corresponding to Claim 8, **characterized in that**
the acid-binding agents added are pyridine, caustic soda or caustic potash.

11. Process for the lithographic production of negative structures for the µm and nm range, **characterized in that**
- a photoresist consisting of a phenolic resin, a light-sensitive component of the general formula I 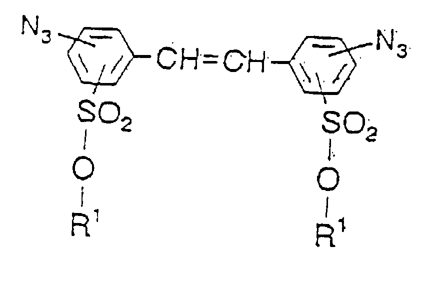
where R¹ is a radical of the general formula II 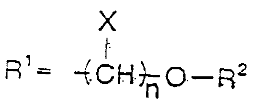
R² is hydrogen, branched or unbranched alkyl,
X is hydrogen, branched or unbranched alkyl, and
n is from 1 to 10,
with the stated meanings for R¹, R²,
X and n, a solvent or solvent mixture and layer-forming and/or layer-stabilizing additives
is employed,
- the resist is applied to the substrate as a layer,
- the resist layer is dried,
- the resist layer is exposed imagewise in the wavelength range from 200 nm to 400 nm,
- the exposed layer is developed with an aqueous-alkaline developer, and
- the resultant structure is dried.

12. Process for the lithographic production of negative structures for the µm and nm range corresponding to Claim 11, where the resist employed comprises a phenolic resin as polymeric binder, a diazidostilbenedisulphonic acid ester as light-sensitive component, a solvent or solvent mixture and layer-forming and/or layer-stabilizing additives, **characterized in that**
the coating of the substrate is carried out using spin coating, roller coating, spray coating or dip coating.

13. Process for the lithographic production of negative structures for the µm and nm range corresponding to Claim 11, where the resist employed comprises a phenolic resin as polymeric binder, a diazidostilbenedisulphonic acid ester as light-sensitive component, a solvent or solvent mixture and layer-forming and/or layer-stabilizing additives, **characterized in that**
layer thicknesses of from 0.3 µm to 10 µm are generated during the coating.

14. Process for the lithographic production of negative structures for the µm and nm range corresponding to Claim 11, where the resist employed comprises a phenolic resin as polymeric binder, a diazidostilbenedisulphonic acid ester as light-sensitive component, a solvent or solvent mixture and layer-forming and/or layer-stabilizing additives, **characterized in that**
the drying process is carried out for from 1 minute to 60 minutes at from 60°C to 120°C.

15. Process for the lithographic production of negative structures for the µm and nm range corresponding to Claim 11, where the resist employed comprises a phenolic resin as polymeric binder, a diazidostilbenedisulphonic acid ester as light-sensitive component, a solvent or solvent mixture and layer-forming and/or layer-stabilizing additives, **characterized in that**
the exposure is carried out using maximum-pressure lamps or lasers.

16. Process for the lithographic production of negative structures for the µm and nm range corresponding to Claim 11, where the resist employed comprises a phenolic resin as polymeric binder, a diazidostilbenedisulphonic acid ester as light-sensitive component, a solvent or solvent mixture and layer-forming and/or layer-stabilizing additives, **characterized in that**
the development of the exposed layers is carried out using alkali metal ion-containing developers with a concentration of from 0.2% by weight to 1.5% by weight or metal ion-free developers with a concentration of from 1% by weight to 5% by weight.

17. Process for the lithographic production of negative structures for the µm and nm range corresponding to Claim 11, where the resist employed comprises a phenolic resin as polymeric binder, a diazidostilbenedisulphonic acid ester as light-sensitive component, a solvent or solvent mixture and layer-forming and/or layer-stabilizing additives, and Claim 16, where alkali metal ion-containing or metal ion-free developers are employed, **characterized in that** the development time is from 10 s to 15 minutes.

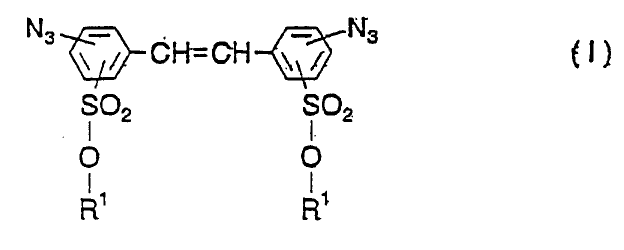

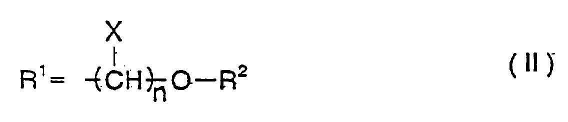

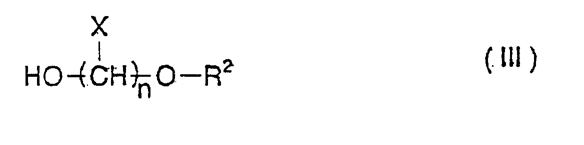

## Revendications

1. Vernis à masquer négatif, à développement alcalino-aqueux, sensible à la lumière, **caractérisé en ce que** le vernis à masquer contient
- une résine phénolique, en tant que liant polymère,
- un ester de l'acide diazidostilbène-disulfonique de formule générale I, en tant que composant sensible à la lumière 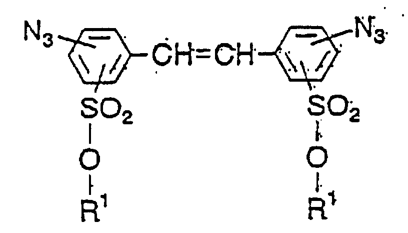
dans laquelle R¹ désigne un résidu de formule générale II 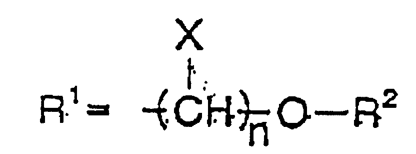
R2 désigne l'hydrogène, un alkyle ramifié et un alkyle non ramifié,
X désigne l'hydrogène, un alkyle ramifié et un alkyle non ramifié, et
n désigne un nombre de 1 à 10,
- un solvant ou un mélange de solvants et
- des additifs de formation et/ou de stabilisation des couches.

2. Vernis à masquer négatif, à développement alcalino-aqueux, sensible à la lumière, qui, selon la revendication 1, contient une résine phénolique en tant que liant polymère, un ester de l'acide diazidostilbène-disulfonique en tant que composant sensible à la lumière, un solvant ou un mélange de solvants et des additifs de formation et/ou de stabilisation des couches, **caractérisé en ce que** le vernis à masquer contient, en tant que liant polymère, un condensat phénol-formaldéhyde ou crésol-formaldéhyde ou un polyvinylphénol non substitué ou substitué ou un mélange de ces derniers.

3. Vernis à masquer négatif, à développement alcalino-aqueux, sensible à la lumière, qui, selon la revendication 1, contient une résine phénolique en tant que liant polymère, un ester de l'acide diazidostilbène-disulfonique en tant que composant sensible à la lumière, un solvant ou un mélange de solvants et des additifs de formation et/ou de stabilisation des couches, **caractérisé en ce que** le vernis à masquer contient, en tant que composant sensible à la lumière, un ester diazidostilbène-acide disulfonique de formule générale I 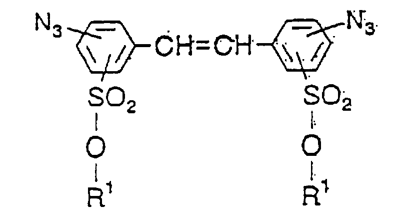 dans laquelle
R¹ désigne un résidu de formule générale II, 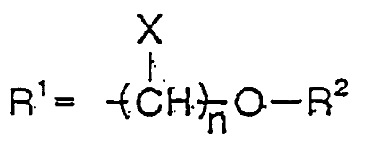
R² désignant l'hydrogène, un alkyle ramifié et non ramifié
X désignant l'hydrogène, un alkyle ramifié et non ramifié et n désignant un nombre de 1 à 10.

4. Vernis à masquer négatif, à développement alcalino-aqueux, sensible à la lumière, qui, selon la revendication 1, contient une résine phénolique en tant que liant polymère, un ester de l'acide diazidostilbène-disulfonique en tant que composant sensible à la lumière, un solvant ou un mélange de solvants et des additifs de formation et/ou de stabilisation des couches, **caractérisé en ce que** le vernis à masquer contient une proportion de matières solides de 5% en poids à 50% en poids.

5. Vernis à masquer négatif, à développement alcalino-aqueux, sensible à la lumière, qui, selon la revendication 1, contient une résine phénolique en tant que liant polymère, un ester de l'acide diazidostilbène-disulfonique en tant que composant sensible à la lumière, un solvant ou un mélange de solvants et des additifs de formation et/ou de stabilisation des couches, et qui est **caractérisé,** selon la revendication 4, en ce que le vernis à masquer possède une proportion de composants sensibles à la lumière dans la matière solide de 5% en poids à 35% en poids.

6. Vernis à masquer négatif, à développement alcalino-aqueux, sensible à la lumière, qui, selon la revendication 1, contient une résine phénolique en tant que liant polymère, un ester de l'acide diazidostilbène-disulfonique en tant que composant sensible à la lumière, un solvant ou un mélange de solvants et des additifs de formation et/ou de stabilisation des couches, **caractérisé en ce que** le vernis à masquer contient, en tant que solvants, des esters, des cétones, des alcools, des aromates, des éthers ou des mélanges de ces derniers.

7. Vernis à masquer négatif, à développement alcalino-aqueux, sensible à la lumière, qui, selon la revendication 1, contient une résine phénolique, en tant que liant polymère, un ester de l'acide diazidostilbène-disulfonique en tant que composant sensible à la lumière, un solvant ou un mélange de solvants et des additifs de formation et/ou de stabilisation des couches, **caractérisé en ce que** le vernis à masquer contient, en tant qu'additifs de formation et/ou de stabilisation des couches, des agents tensioactifs, des agents de lissage ou des promoteurs d'adhésion.

8. Procédé pour la préparation de composants sensibles à la lumière de formule générale I 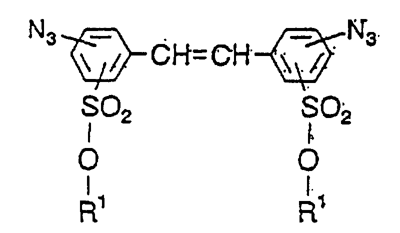 pour des vernis à masquer négatifs, à développement alcalino-aqueux, **caractérisé en ce**
- **qu'**un sel disodique de l'acide diazidostilbène-disulfonique est soumis à une sulfochloration à l'aide de chlorure de thionyle, de telle sorte que l'on ajoute à la quantité de sel disodique des quantités stoechiométriques de diméthylformamide et
- **que** l'on fasse réagir le disulfochlorure de diazidostilbène obtenu avec un alcool de formule générale III 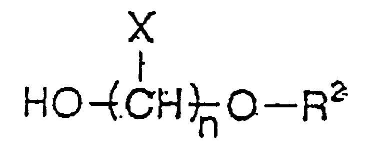
dans laquelle
R² désigne l'hydrogène, un alkyle ramifié et un alkyle non ramifié,
X désigne l'hydrogène, un alkyle ramifié et un alkyle non ramifié, et
n désigne un nombre de 1 à 10, en présence d'additifs de fixation des acides.

9. Procédé pour la préparation de composants sensibles à la lumière de formule générale I 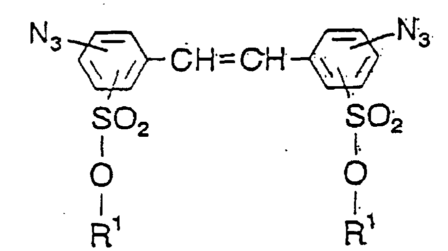 selon la revendication 8, **caractérisé en ce que** l'on ajoute le chlorure de thionyle sous forme d'excès.

10. Procédé de préparation de composants sensibles à la lumière de formule I 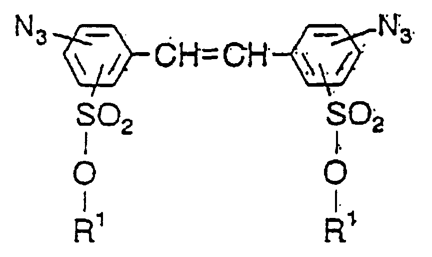 selon la revendication 8, **caractérisé en ce que** l'on ajoute, en tant qu'agents de fixation des acides, de la pyridine, de la soude caustique ou de la potasse caustique.

11. Procédé pour la fabrication lithographique de structures négatives pour le domaine micrométrique et nanométrique, **caractérisé en ce**
- **que** l'on utilise un vernis à masquer photo résistant se composant d'une résine phénolique, d'un composant sensible à la lumière de formule général I 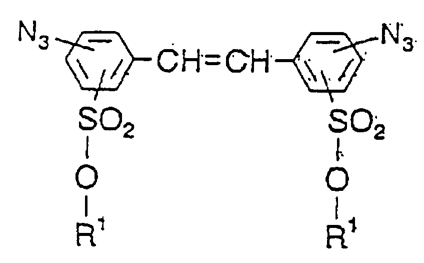
R¹ désignant un résidu de formule générale II, 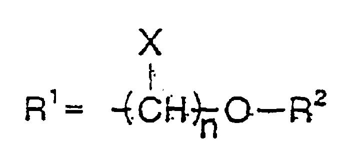
R² désignant l'hydrogène, un alkyle ramifié et un alkyle non ramifié,
X désignant l'hydrogène, un alkyle ramifié et un alkyle non ramifié, et
n désignant un nombre de 1 à 10,
avec les désignations indiquées pour R¹, R², X et n, un solvant ou un mélange de solvants et des additifs de formation et/ou de stabilisation des couches,
- **que** l'on applique le vernis à masquer en tant que couche sur le substrat,
- **que** l'on sèche la couche de vernis à masquer,
- **que** l'on illumine la couche pour former une image dans le domaine de longueurs d'onde de 200 nm à 400 nm,
- **que** l'on développe la couche exposée à l'aide d'un agent de développement alcalino-aqueux et
- **que** l'on sèche la structure obtenue.

12. Procédé pour la fabrication lithographique de structures négatives pour le domaine micrométrique et nanométrique selon la revendication 11, pour lequel le vernis à masquer utilisé contient une résine phénolique en tant que liant polymère, un ester de l'acide diazidostilbène-disulfonique en tant que composant sensible à la lumière, un solvant ou un mélange de solvants et des additifs de formation et/ou de stabilisation des couches, **caractérisé en ce que** l'on utilise pour le revêtement du substrat, le procédé de revêtement par centrifugation (spin coating en anglais), l'application au rouleau, le revêtement par pulvérisation, le revêtement par aérosol ou le revêtement par immersion.

13. Procédé pour la fabrication lithographique de structures négatives pour le domaine micrométrique et nanométrique selon la revendication 11, pour lequel le vernis à masquer utilisé contient une résine phénolique en tant que liant polymère, un ester de l'acide diazidostilbène-disulfonique en tant que composant sensible à la lumière, un solvant ou un mélange de solvants et des additifs de formation et/ou de stabilisation des couches, **caractérisé en ce que** l'on produit, lors du revêtement, des épaisseurs de couche de 0,3 micron à 10 microns.

14. Procédé pour la fabrication lithographique de structures négatives pour le domaine micrométrique et nanométrique selon la revendication 11, pour lequel le vernis à masquer utilisé contient une résine phénolique en tant que liant polymère, un ester de l'acide diazidostilbène-disulfonique en tant que composant sensible à la lumière, un solvant ou un mélange de solvants et des additifs de formation et/ou de stabilisation des couches, **caractérisé en ce que** l'on effectue le processus de séchage pendant une durée de 1 minute à 60 minutes à une température de 60°C à 120 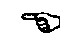 C.

15. Procédé pour la fabrication lithographique de structures négatives pour le domaine micrométrique et nanométrique selon la revendication 11, pour lequel le vernis à masquer utilisé contient une résine phénolique en tant que liant polymère, un ester de l'acide diazidostilbène-disulfonique en tant que composant sensible à la lumière, un solvant ou un mélange de solvants et des additifs de formation et/ou de stabilisation des couches, **caractérisé en ce que** l'on utilise, en vue de l'exposition, des lampes haute pression ou des lasers.

16. Procédé pour la fabrication lithographique de structures négatives pour le domaine micrométrique et nanométrique selon la revendication 11, pour lequel le vernis à masquer utilisé contient une résine phénolique en tant que liant polymère, un ester de l'acide diazidostilbène-disulfonique en tant que composant sensible à la lumière, un solvant ou un mélange de solvants et des additifs de formation et/ou de stabilisation des couches, **caractérisé en ce que** l'on utilise, pour le développement des couches exposées, des agents de développement contenant des ions métalliques alcalins, à une concentration de 0,2% en poids à 1,5% en poids ou des agents de développement exempts d'ions métalliques, à une concentration de 1% en poids à 5% en poids.

17. Procédé pour la fabrication lithographique de structures négatives pour le domaine micrométrique et nanométrique selon la revendication 11, le vernis à masquer utilisé contenant une résine phénolique en tant que liant polymère, un ester de l'acide diazidostilbène-disulfonique en tant que composant sensible à la lumière, un solvant ou un mélange de solvants et des additifs de formation et/ou de stabilisation des couches, et selon la revendication 16, des agents de développement contenant des ions métalliques alcalins ou exempts d'ions métalliques étant utilisés, **caractérisé en ce que** le temps de développement est de 10 secondes à 15 minutes.
